# EUROPÄISCHE PATENTSCHRIFT

(11) **EP 2 153 476 B1**
(45) Veröffentlichungstag und Bekanntmachung des Hinweises auf die Patenterteilung: **24.08.2011**
(21) Anmeldenummer: 09721193.2
(22) Anmeldetag: 27.05.2009
(51) Int. Cl.: H01L 41/09, G02B 7/10

(54) **ULTRASCHALLAKTOR**
ULTRASONIC ACTUATOR
ACTIONNEUR À ULTRASONS

(30) Priorität: 02.06.2008 DE 102008026429
(43) Veröffentlichungstag der Anmeldung: 17.02.2010
(73) Patentinhaber: Physik Instrumente (PI) GmbH & Co. KG, 76228 Karlsruhe (DE)
(72) Erfinder: WISCHNEWSKIJ, Alexej, 76744 Wörth (DE); WISCHNEWSKIY, Wladimir, 76337 Waldbronn (DE); BRÜGGEMANN, Ulrich, 75175 Pforzheim (DE); HÜBNER, Reinhard, 76337 Waldbronn (DE); LINDIG, Siegfried, 07548 Gera (DE)
(74) Vertreter: Meissner, Bolte & Partner
(86) Internationale Anmeldenummer: PCT/EP2009/056436
(87) Internationale Veröffentlichungsnummer: WO 2009/147037

(56) Entgegenhaltungen:
- EP-A- 0 924 778
- AOYAGI M ET AL: "ULTRASONIC MOTOR BASED ON COUPLED LONGITUDINAL-BENDING VIBRATIONS OF A DIAGONALLY SYMMETRIC PIEZOELECTRIC CERAMIC PLATE" ELECTRONICS & COMMUNICATIONS IN JAPAN, PART II - ELECTRONICS, WILEY, HOBOKEN, NJ, US, Bd. 79, Nr. 6, 1. Juni 1996 (1996-06-01), Seiten 60-67, XP000637373 ISSN: 8756-663X
- YARALIOGLU G G ET AL: "Finite element modeling of capacitive micromachined ultrasonic transducers" PROCEEDINGS OF THE SPIE - THE INTERNATIONAL SOCIETY FOR OPTICAL ENGINEERING SPIE-INT. SOC. OPT. ENG USA, Bd. 5750, Nr. 1, 2005, Seiten 77-86, XP002541790 ISSN: 0277-786X
- JIANN-GANG DENG ET AL: "Fourier series method for plane elastic problems of polygonal domain" COMPUTER METHODS IN APPLIED MECHANICS AND ENGINEERING ELSEVIER NETHERLANDS, Bd. 190, Nr. 35-36, 8. Juni 2001 (2001-06-08), Seiten 4569-4585, XP002541791 ISSN: 0045-7825

## Beschreibung

Die Erfindung betrifft einen Ultraschallaktor, vorzugsweise für den Einsatz in einem Ultraschall motor, in Form einer piezoelektrischen Platte mit einer Länge L, einer Höhe H und einer Dicke t, wobei die piezoelektrische Platte eine Quer-Symmetrieebene Sq, eine Längs-Symmetrieebene SI und wenigstens zwei Hauptflächen aufweist, und die piezoelektrische Platte zumindest zwei symmetrisch zu der Symmetrieebene Sq angeordnete Generatoren zur Erzeugung von Ultraschallstehwellen umfasst, gemäß Oberbegriff des Patentanspruchs 1.

Derartige Ultraschallaktoren bzw. die diese umfassenden Ultraschallmotoren können in miniaturisierten, preiswerten Geräten mit geringem Energieverbrauch, wie beispielsweise in Miniaturfotoapparaten, Handyobjektiven, Miniaturspeichereinrichtungen und ähnlichen Geräten, verwendet werden, wo kleine Abmessungen, hohe Positioniergenauigkeit und ein niedriger Energieverbrauch durch den Antrieb erforderlich sind.

Aus den Druckschriften US 5,672,903 und US 5,665,918 sind Ultraschallaktoren für Ultraschallmotoren bekannt, die als komplexe zusammengesetzte Vibratoren konzipiert sind und aus einem Resonanzkörper, auf dem piezoelektrische Erregerplatten aufgeklebt sind, bestehen. Der Nachteil dieser Aktoren liegt darin, dass sie einen relativ komplizierten Aufbau aufweisen und ihre Herstellung aufwendig ist. Daher scheiden sie als preiswertes Massenprodukt für den Einsatz in miniaturisierten Geräten aus.

Aus der Druckschrift Manabu Oyagi et al., "Ultrasonic Motor Based on Coupled Longitudinal-Bending Vibrations of a Diagonally Symmetric Piezoelectric Plate", Electronics and Communication in Japan, part 2, vol. 79, no. 6, p. 60-67, (1996) sind Ultraschallmotoren mit diagonalsymmetrisch ausgeführten Piezokeramikplatten bekannt.

Aus der Druckschrift US 6,765,335 ist ferner ein Ultraschallaktor für einen Ultraschallmotor bekannt, bei dem der Resonanzkörper als piezoelektrische Platte mit rechteckiger Form ausgebildet ist (Fig. 20). Dieser Ultraschallaktor zeichnet sich zwar durch eine einfache Konstruktion und eine leicht beherrschbare Herstellungstechnologie aus, weshalb er als preiswertes Massenprodukt geeignet erscheint. Jedoch besteht bei diesem Ultraschallaktor der Nachteil, dass für dessen Betrieb eine relativ hohe elektrische Leistung er-forderlich ist, wodurch ein erhöhter Energieverbrauch resultiert. Daher scheidet ein solcher Ultraschallaktor für die Verwendung in Miniaturvorrichtungen mit entsprechend erforderlichem geringen Energieverbrauch aus.

Die Aufgabe der Erfindung besteht deshalb darin, einen Ultraschallaktor bereitzustellen, der einerseits eine einfache Konstruktion aufweist und sich durch eine leicht beherrschbare Herstellungstechnologie auszeichnet sowie andererseits einen geringen elektrischen Energieverbrauch bei zugleich höherer Betriebsstabilität bzw. Sicherheit besitzt.

Diese Aufgabe wird erfindungsgemäß gelöst durch einen Ultraschallaktor der eingangs genannten Art, bei dem die piezoelektrische Platte eine wenigstens acht Seitenflächen umfassende Form aufweist, wobei wenigstens zwei der Seitenflächen zur Kontaktierung von anzutreibenden Elementen vorgesehene Arbeitsflächen sind, und wenigstens zwei der Seitenflächen zur Halterung der piezoelektrischen Platte vorgesehene Halteflächen sind, und die übrigen Seitenflächen freie Flächen sind, wobei zumindest vier freie Flächen unter einem gleichen Winkel α zu der Längs-Symmetrieebene SI und/oder unter einem gleichen Winkel ϕ zu der Quer-Symmetrieebene Sq angeordnet sind. Dabei kann die Kontaktierung der anzutreibenden Elemente durch die Arbeitsflächen direkt oder indirekt sein. Ebenso kann die Halterung der piezoelektrischen Platte durch die Halteflächen direkt oder indirekt erfolgen.

Es kann es vorteilhaft sein, dass die Arbeitsflächen eine Breite n aufweisen, und die Halteflächen eine Breite m aufweisen, und das Verhältnis Plattenlänge L zu n und/oder das Verhältnis Plattenhöhe H zu m im Bereich zwischen 1,1 bis 9 liegt und vorzugsweise etwa gleich 5 ist. Dies führt zu einem besonders günstigen Betriebsverhalten des Ultraschallaktors.

Weiterhin kann es vorteilhaft sein, dass das Verhältnis L zu H im Bereich zwischen 1,5 und 3 liegt und vorzugsweise etwa gleich 2 ist. Auch diese Ausführungsform führt zu einem günstigen Betriebsverhalten des Ultraschallaktors.

Zudem kann es vorteilhaft sein, dass das Verhältnis L zu Plattendicke t im Bereich zwischen 5 und 15 liegt und vorzugsweise etwa gleich 10 ist. Diese Ausführungsform hat ebenso eine positive Auswirkung auf das Betriebsverhalten des Ultraschallaktors.

Es kann günstig sein, dass die freien Flächen wenigstens abschnittsweise konkav und/oder konvex geformt sind. Dies erweitert die konstruktiven Möglichkeiten des Ultraschallaktors.

Es kann auch günstig sein, dass jeder der Generatoren eine Erregerelektrode und eine allgemeine Elektrode umfasst, die auf den Hauptflächen der piezoelektrischen Platte angeordnet sind, und zwischen der Erregerelektrode und der allgemeinen Elektrode eine piezoelektrische Keramik angeordnet ist. Dies vereinfacht die Konstruktion des Ultraschallaktors.

Außerdem kann es günstig sein, dass jeder der Generatoren mehrere Schichten von Erregerelektroden, allgemeinen Elektroden und jeweils zwischen diesen angeordnete Schichten aus piezoelektrischer Keramik aufweist, wobei besagte Schichten parallel zu den Hauptflächen der piezoelektrischen Platte angeordnet sind. Dies verringert die erforderliche Erregerspannung des Ultraschallaktors.

Darüber hinaus kann es günstig sein, dass zumindest eine der Arbeitsflächen wenigstens ein Friktionselement oder wenigstens einen Stößel aufweist. Dies erweitert die konstruktiven Ausführungsmöglichkeiten des Ultraschallaktors.

Es kann von Vorteil sein, dass wenigstens eine der Arbeitsflächen zumindest abschnittsweise eine Führungsnut aufweist. Auch dies erweitert die konstruktiven Ausführungsmöglichkeiten des Ultraschallaktors.

Zudem kann es von Vorteil sein, dass das Friktionselement und/oder der Stöβel und/oder die Führungsnut an der Oberfläche zumindest abschnittsweise eine abriebfeste Schicht aufweist bzw. aufweisen. Dadurch erhöht sich die Lebensdauer des Ultraschallaktors.

Ebenso kann es von Vorteil sein, dass zumindest eine der Halteflächen wenigstens ein Fixierelement oder zumindest abschnittsweise eine Fixiernut aufweist. Dies erhöht die Positioniergenauigkeit.

Selbstverständlich sind auch Kombinationen der zuvor beschriebenen vorteilhaften Ausführungsformen möglich.

Die Erfindung wird nachfolgend anhand von Ausführungsbeispielen unter Zuhilfenahme von Figuren näher erläutert.

Es zeigen:
- Fig. 1: Schematische Darstellung einer ersten Ausführungsform des erfindungsgemäßen Ultraschallaktors in perspektivischer Dar- stellung (oben) und in Draufsicht (unten, Darstellung 3)
- Fig. 2, 3: Schematische Darstellung verschiedener weiterer Ausfüh- rungsformen des erfindungsgemäßen Ultraschallaktors
- Fig. 4: Schematische Darstellung unterschiedlicher Konstruktions- varianten von Generatoren für eine Ultraschallstehwelle
- Fig. 5: Schaltbild zur Darstellung des Anschlusses des erfindungsgemä- β en Ultraschallaktors an einer elektrischen Erregervorrichtung
- Fig. 6: Darstellung der Abhängigkeit der elektrischen Impedanz des erfindungsgemäßen Ultraschallaktors von der Frequenz der elektrischen Erregerspannung (Darstellung 25) bzw. der Fre- quenzabhängigkeit des Winkels φ zwischen einer elektrischen Erregerspannung U und einem Strom I eines Generators (Dar- stellung 26)
- Fig. 7: Schematische Darstellung von Deformationszuständen des erfin- dungsgemäßen Ultraschallaktors
- Fig. 8: Schematische Darstellung der Bewegungsbahnen von Material- punkten des erfindungsgemäßen Ultraschallaktors
- Fig. 9: Schematische Darstellung verschiedener Ausführungsformen des Friktionselementes oder des Stößels
- Fig. 10, 11: Schematische Darstellung verschiedener weiterer Ausführungs- formen des erfindungsgemäßen Ultraschallaktors
- Fig. 12-18: Schematische Darstellung unterschiedlicher Anwendungsbei- spiele des erfindungsgemäßen Ultraschallaktors

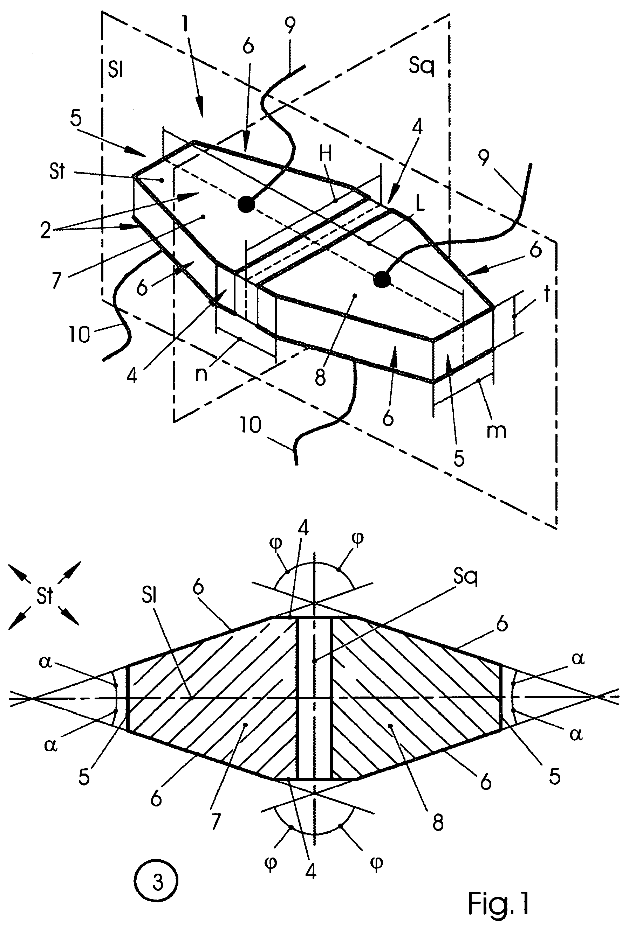

Fig. 1 zeigt eine erste Ausführungsform des erfindungsgemäßen Ultraschallaktors. Dieser besteht aus einer piezoelektrischen Platte 1 mit einer Längs-Symmetrieebene SI und einer senkrecht dazu angeordneten Quer-Symmetrieebene Sq. Die piezoelektrische Platte 1 weist zwei sich gegenüberliegende, im Wesentlichen parallel zueinander liegende Hauptflächen 2 auf, die senkrecht zu den Symmetrieebenen SI und Sq angeordnet sind. Die sich gegenüberliegenden Hauptflächen 2 sind über acht Seitenflächen miteinander verbunden, wobei zwei Seitenflächen Arbeitsflächen 4, zwei Seitenflächen Halteflächen 5 und die übrigen vier Seitenflächen freie Flächen 6 sind. Bezogen auf die Ebene St, die sowohl senkrecht zur Symmetrieebene SI, als auch senkrecht zur Symmetrieebene Sq angeordnet ist und die mit einer der Hauptflächen 2 zusammenfallen oder sich zwischen diesen befinden kann, hat die Querschnittsfläche der piezoelektrischen Platte eine achteckige Form (siehe hierzu auch Darstellung 3 der Fig. 1).

Die Arbeitsflächen 4 sind im Wesentlichen parallel zur Symmetrieebene SI, die Halteflächen 5 im Wesentlichen parallel zur Symmetrieebene Sq und die freien Flächen 6 unter dem gleichen Winkel α zur Symmetrieebene SI und unter dem gleichen Winkel ϕ zur Symmetrieebene Sq angeordnet.

Die piezoelektrische Platte 1 hat die Höhe H, die dem Abstand der beiden Arbeitsflächen 4 entspricht, und die Länge L, die dem Abstand der beiden Halteflächen 5 entspricht. Die Breite der Arbeitsflächen 4 ist gleich n, und die Breite der Halteflächen 5 ist gleich m. Darüber hinaus hat die piezoelektrische Platte 1 die Dicke t. Beim erfindungsgemäßen Ultraschallaktor liegt das Verhältnis der Länge L zur Höhe H im Bereich von 1,5 bis 3. Optimal ist es, wenn das Verhältnis L/H in etwa gleich 2 ist.

Die piezoelektrische Platte 1 umfasst zwei Generatoren 7 und 8 zur Erzeugung von Ultraschallstehwellen, die symmetrisch zur Symmetrieebene Sq angeordnet sind. Jeder der Generatoren 7 und 8 befindet sich in Symmetrie bezogen auf die Symmetrieebene SI und in Asymmetrie bezogen auf die Symmetrieebene Sq. Zum Anschluss einer elektrischen Erregervorrichtung besitzen die Generatoren 7 und 8 Anschlüsse 9 und 10.

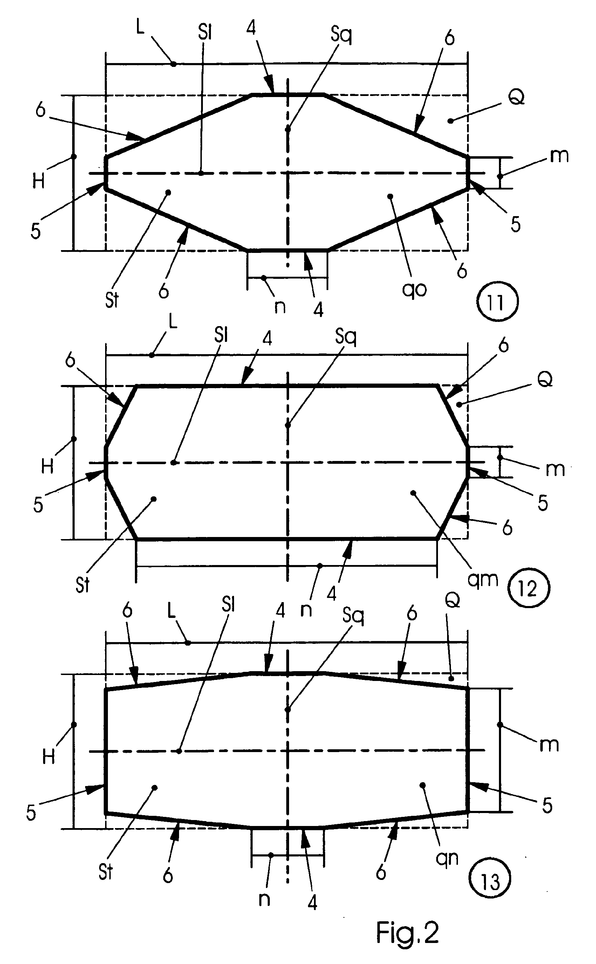

Fig. 2 zeigt verschiedene Ausführungsformen des erfindungsgemäßen Ultraschallaktors mit unterschiedlichen Breiten n der Arbeitsflächen 4 und/oder unterschiedlichen Breiten m der Halteflächen 5. Das Verhältnis der Länge L zur Breite n der Arbeitsfläche 4 und das Verhältnis der Höhe H zur Breite m der Haltefläche 5 kann sich im Bereich von 1,1 bis 9 bewegen. Optimal ist es, wenn das Verhältnis L/n oder H/m in etwa gleich 5 ist. Die Stärke t ist ungefähr gleich 0,1 L.

Die Darstellungen 11, 12 und 13 von Fig. 2 zeigen beispielhaft drei Fälle für die Ausführung der piezoelektrischen Platte 1. Für den ersten Fall (Darstellung 11) gilt L/n=H/m=5, für den zweiten Fall (Darstellung 12) gilt L/n=1,2 und H/m=5, für den dritten Fall (Darstellung 13) gilt L/n=5 und H/m=1,2. Die Querschnittsfläche der piezoelektrischen Platte 1 bezogen auf die Ebene St beträgt im ersten Fall qo, im zweiten Fall qm und im dritten Fall qn.

In den Darstellungen 11, 12 und 13 von Fig. 2 ist gestrichelt die Rechteckform der aus dem Stand der Technik nach Druckschrift US 6,765,335 bekannten piezoelektrischen Platte dargestellt, die einen direkten Vergleich der entsprechenden Querschnittsfläche Q bezogen auf die Ebene St mit den Querschnittsflächen qo, qn und qm zulässt.

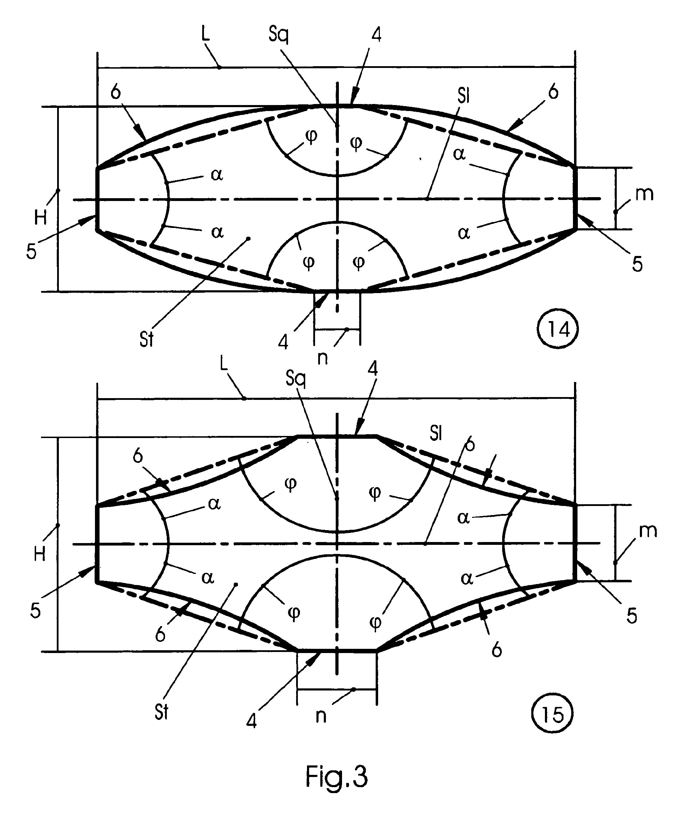

Fig. 3 zeigt in den Darstellungen 14 und 15 weitere Ausführungsformen des erfindungsgemäßen Ultraschallaktors, bei welchem die piezoelektrische Platte 1 freie Flächen 6 aufweist, die eine konvexe Form (Darstellung 14) bzw. eine konkave Form (Darstellung 15) besitzen.

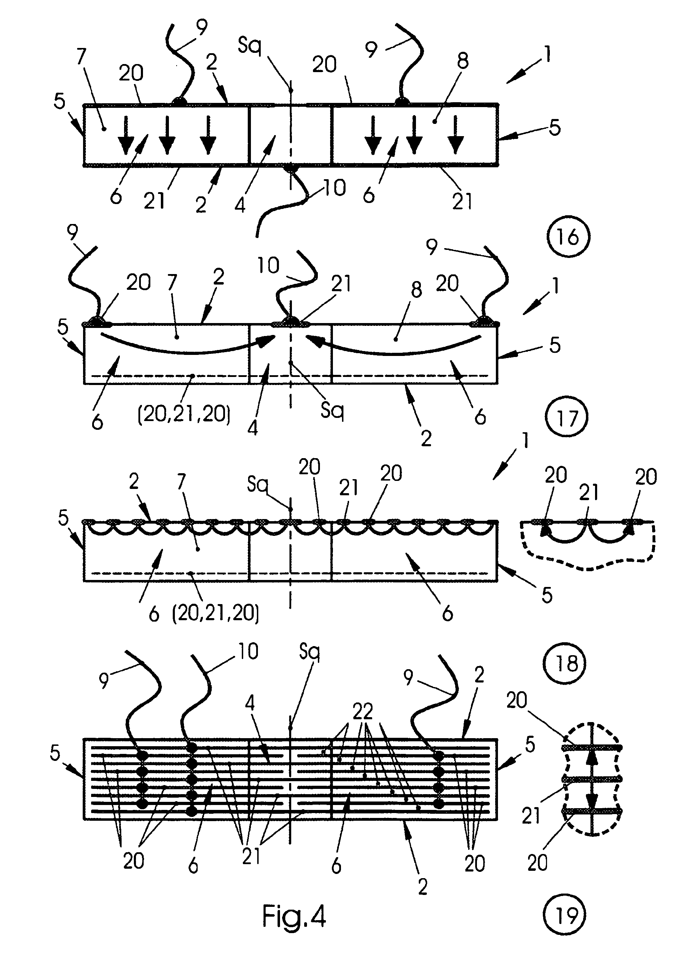

Fig. 4 enthält die schematische Darstellung unterschiedlicher Konstruktionsvarianten von Generatoren für eine Ultraschallstehwelle. In den ersten drei Varianten gemäß den Darstellungen 16, 17 und 18 ist die piezoelektrische Platte 1 als monolithischer Körper aus Piezokeramik ausgeführt, und jeder der Generatoren 7 und 8 umfasst eine Erregerelektrode 20, eine gemeinsame Elektrode 21 und piezoelektrische Keramik, die sich zwischen den besagten Elektroden befindet.

Bei der in Darstellung 16 gezeigten Ausführungsform befinden sich die Erregerelektroden 20 und die allgemeinen Elektroden 21 auf den gegenüberliegenden Hauptflächen 2. Bei den in den Darstellungen 17 und 18 gezeigten Ausführungsformen befinden sich die Erregerelektroden 20 und die allgemeinen Elektroden 21 auf ein und derselben Hauptfläche 2. Die Elektroden können also auf einer oder auf zwei Hauptflächen der piezoelektrischen Platte 1 angeordnet sein. In beiden Fällen werden vorzugsweise streifenförmige Elektroden verwendet.

Darstellung 19 in Fig. 4 zeigt eine weitere mögliche Ausführungsform der Generatoren 7 und 8, wobei diese Generatoren aus Schichten der Erregerelektroden 20, aus Schichten der allgemeinen Elektroden 21 und aus zwischen diesen Schichten angeordneten piezokeramischen Schichten 22 bestehen. Alle Schichten sind parallel zu den Hauptflächen 2 der piezoelektrischen Platte 1 angeordnet. Beim Sintern der Keramik verbinden sich die Schichten der Elektroden 20 und 21 und die piezokeramischen Schichten 22 zwischen den Elektroden so miteinander, dass die piezoelektrische Platte 1 einen monolithischen Multilayerkörper bildet.

In den Darstellungen 16 bis 19 der Fig. 4 ist die Polarisationsrichtung der Piezokeramik der piezoelektrischen Platte 1 durch Pfeile dargestellt.

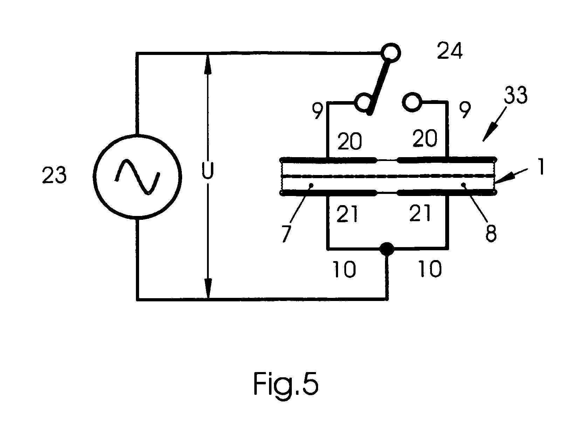

Fig. 5 zeigt ein Schaltbild, das den Anschluss des erfindungsgemäßen Ultraschallaktors an einer elektrischen Erregervorrichtung 23 schematisch darstellt. Hierbei stellt die elektrische Erregervorrichtung 23 eine elektrische Spannung U fließt durch den Generator 7 bzw. 8 der Strom I. Die Schaltung umfasst einen Umschalter 24 für die Generatoren 7 und 8.

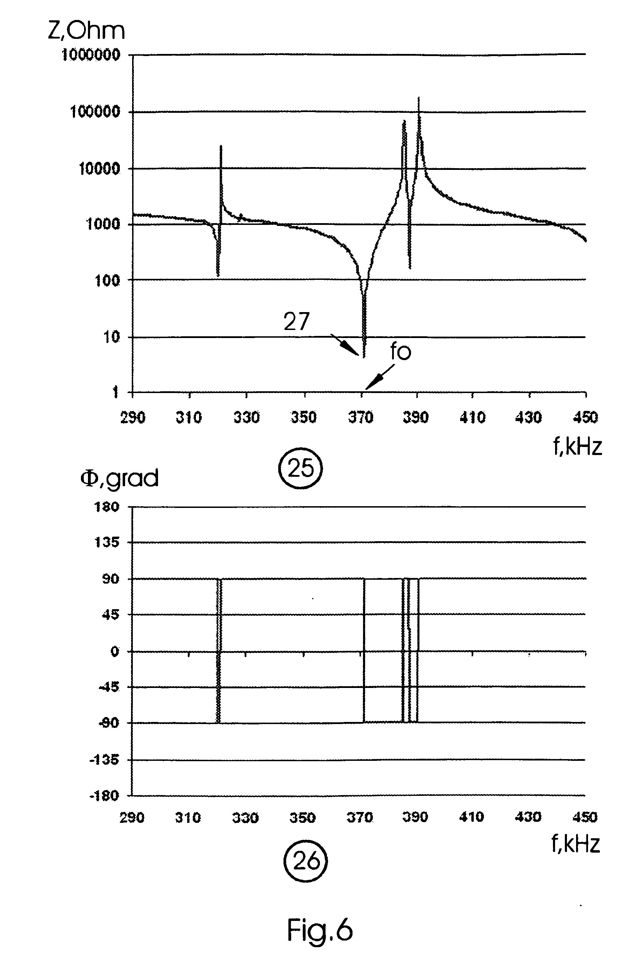

Fig. 6 veranschaulicht in Darstellung 25 die Abhängigkeit der elektrischen Impedanz des erfindungsgemäßen Ultraschallaktors von der Frequenz der elektrischen Erregerspannung, während in Darstellung 26 die Frequenzabhängigkeit des Winkels φ zwischen einer elektrischen Erregerspannung U und einem Strom I des Generators 7 bzw. 8 gezeigt ist. Die jeweiligen Abhängigkeiten sind für eine piezoelektrische Platte, gefertigt aus der Piezokeramik PIC 181 der Firma PI Ceramic GmbH mit den Abmessungen L=10 mm, H=5 mm, n=2 mm, m=1 mm und t=1 mm, angegeben. Der Peak 27 stellt die Resonanz bei der Frequenz fo=371 kHz dar, wodurch sich im Oszillator eine asymmetrische Stehwelle ausbildet, die im erfindungsgemäßen Ultraschallaktor zum Einsatz kommt.

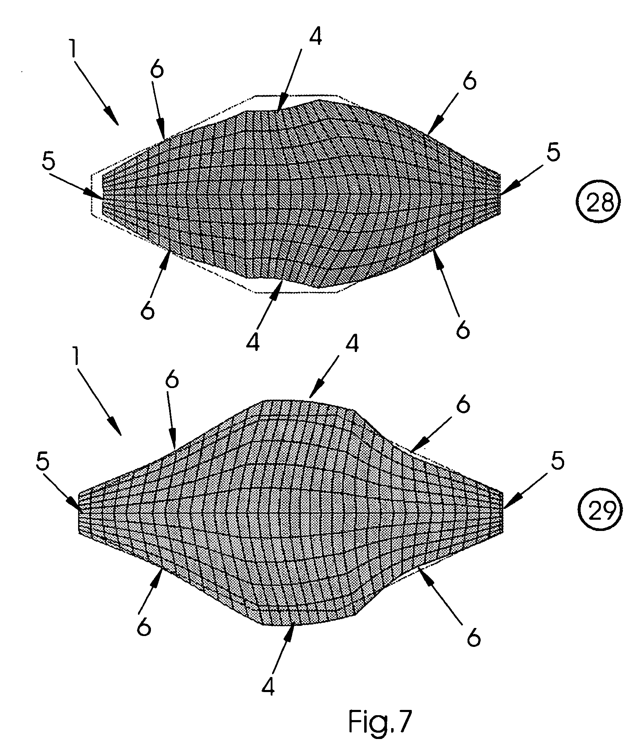

Fig. 7 verdeutlicht in den Darstellungen 28 und 29 die maximalen Deformationen der piezoelektrischen Platte 1, wenn in ihr während des Betriebs eine asymmetrische Stehwelle erzeugt wird. Die Darstellungen sind, bezogen auf die Zeit, um eine halbe Schwingungsperiode verschoben.

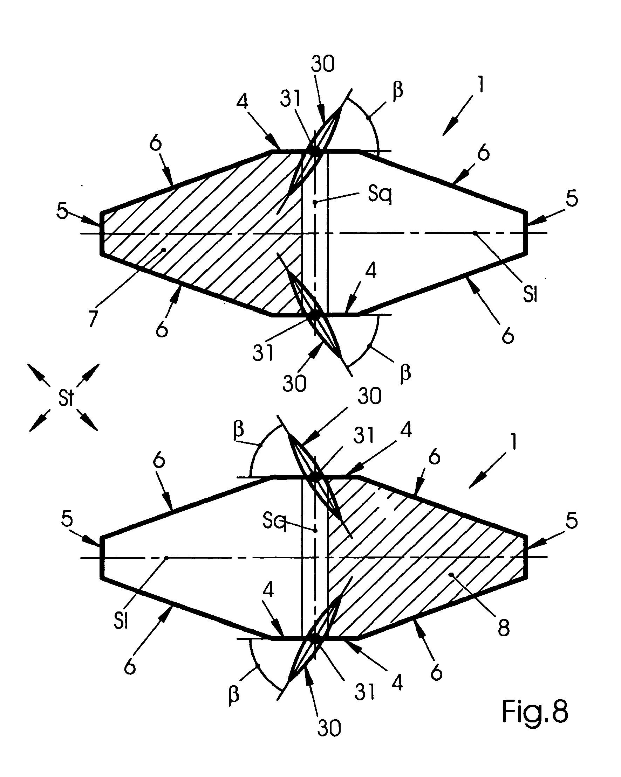

Fig. 8 zeigt Bewegungsbahnen 30 der sich im Zentrum der Arbeitsflächen 4 der piezoelektrischen Platte 1 befindenden Punkte 31 bei einer Erzeugung einer asymmetrischen Stehwelle in ihr. Die Bewegungsbahnen 30 sind, bezogen auf die Oberfläche der Hauptflächen 4, unter dem Winkel β geneigt.

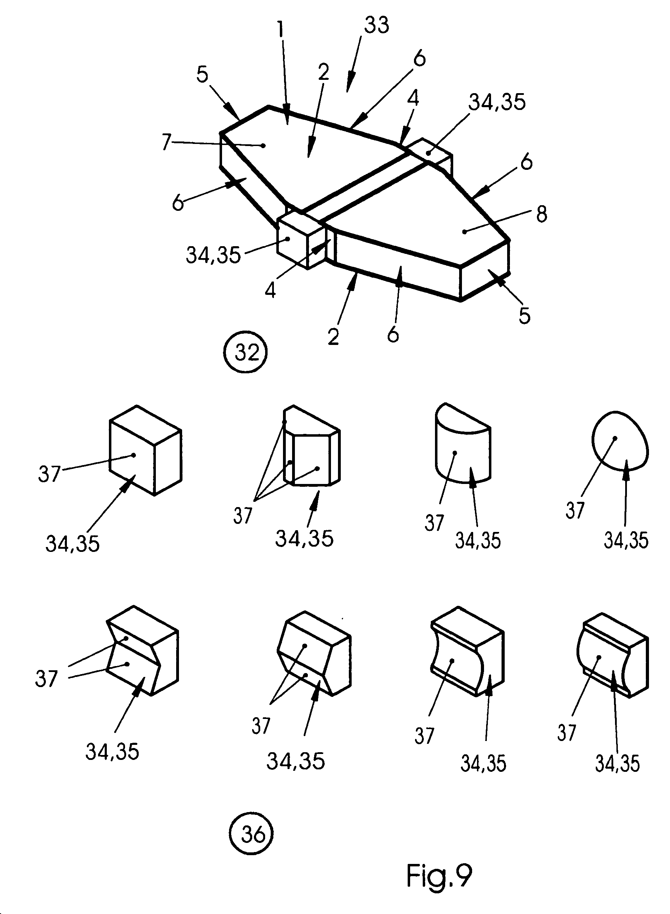

Fig. 9 zeigt in der Darstellung 32 eine Ausführungsform des erfindungsgemäßen Ultraschallaktors 33, dessen Arbeitsflächen 4 ein Friktionselement 34 oder einen Stößel 35 aufweisen. Die Darstellung 36 der Fig. 9 zeigt einige der möglichen Ausführungsformen für das Friktionselement 34 oder den Stößel 35.

Der Unterschied zwischen dem Friktionselement 34 und dem Stößel 35 besteht darin, dass das Friktionselement 34 aus einem harten, abriebfesten nen die gleiche geometrische Form aufweisen. Das Friktionselement 34 ist aus einer harten abriebfesten Sorte von Oxidkeramik, z. B. aus Keramik auf der Basis von Aluminiumoxid, Zirkoniumoxid oder einer Mischung aus beiden oder einer Mischung mit anderen Materialien gefertigt. Möglich ist hierbei auch Keramik auf der Basis von Aluminiumnitrid, Aluminiumkarbid, Siliziumkarbid oder aus Metallkeramik auf der Basis von Wolframkarbid oder Titankarbid. Denkbar ist auch, dass das Friktionselement 34 aus festen Monokristallen von z.B. Korund, Rubin, Saphir, Quarz oder Beryllium besteht. Weiterhin sind als Werkstoff für das Friktionselement 34 auch Materialmischungen möglich, die aus Teilchen eines harten abriebfesten Materials und Bindematerial bestehen. Als Bindematerial können hochtemperaturbeständige Kunststoffe, wie z.B. Polyarylamid mit teilkristalliner Struktur, verwendet werden.

Der Stößel 34 ist aus relativ weichem Material gefertigt, bei welchem der Young'sche Modul und der Temperaturausdehnungskoeffizient in etwa dem Young schen Modul und dem Temperaturausdehnungskoeffizienten der Piezokeramik entspricht. Das trifft z. B. auf Sorten weicher Oxidkeramik zu. Zur Reduktion bzw. zur Verhinderung von Abrieb ist die Friktionsoberfläche des Stößels 35 mit einer dünnen, abriebfesten Schicht 37 bedeckt. Als abriebfeste Schicht 37 kann abriebfestes Glas oder mit Teilen eines abriebfesten Materials angereichertes Glas verwendet werden. Denkbar ist auch eine Schicht chemisch abgeschiedenen Nickels oder Chroms. Es kann auch eine Schicht aus Aluminiumoxid oder Zirkoniumoxid, aufgetragen mittels Plasmaabscheidung, oder eine Schicht, die aus der Gasphase abgeschiedene kleine Diamantkristalle enthält, verwendet werden. Denkbar ist auch die Verwendung von Schichten in Form dünner Beläge aus beispielsweise CrN, CrCN, (Cr, W)N, (Cr, AI)N, NbN-CrN, TiN, TiCN, (Ti,AI)N oder V₂O₅.

Das Friktionselement 34 oder der Stößel 35 können durch Aufschweißen oder Aufkleben auf den Arbeitsflächen 4 mit der piezoelektrischen Platte 1 befestigt sein. Das Aufschweißen erfolgt hierbei mit Hilfe leicht schmelzender Gläser oder mittels anderer Materialien, die eine chemische Verbindung der Piezokeramik mit dem Material des Friktionselements 34 oder des Stößels 35 eingehen. Das Aufkleben kann mittels Epoxydharz oder mit Hilfe anderer ähnlicher Kleber erfolgen.

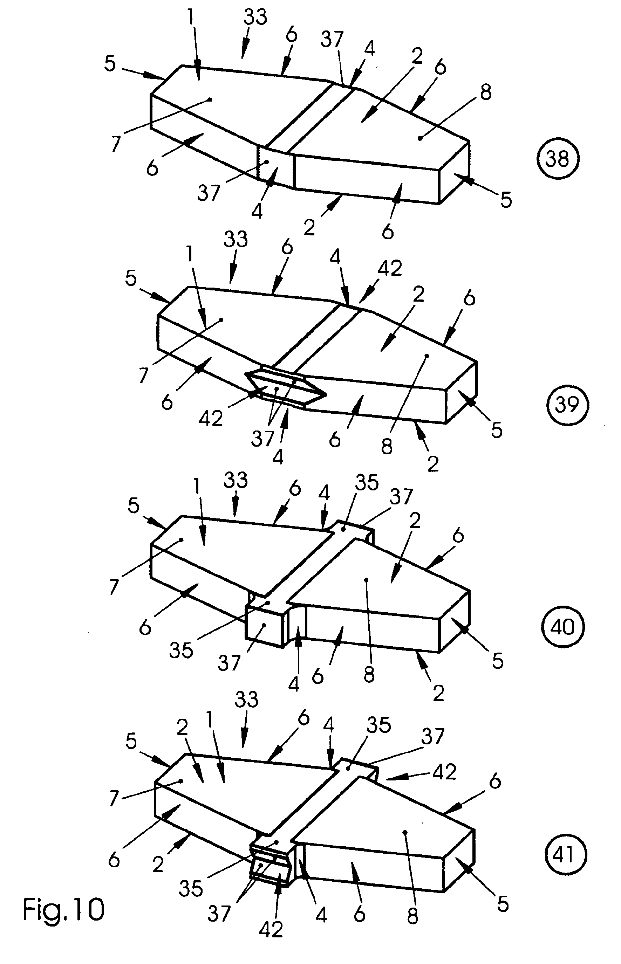

Fig. 10 zeigt in den Darstellungen 38 bis 41 weitere mögliche Ausführungsformen des erfindungsgemäßen Ultraschallaktors. Bei dem in Darstellung 38 der Fig. 10 gezeigten Ultraschallaktor 33 haben die Arbeitsflächen 4 keine Friktionselemente 34 oder Stößel 35. In diesem Fall ist die abriebfeste Schicht 37 direkt auf die piezokeramische Oberfläche der Arbeitsflächen 4 aufgetragen. Bei dem in Darstellung 39 der Fig. 10 gezeigten Ultraschallaktor 33 weisen die Arbeitsflächen 4 Führungsnuten 42 auf. Die Führungsnuten 42 haben im Querschnitt betrachtet beispielsweise eine dreieckige, runde, quadratische oder trapezförmige Form. Die Oberflächen der Führungsnuten 42 können mit einer abriebfesten Schicht 37 versehen sein. Außerdem kann diese Oberfläche mit einer dünnen Graphit- oder Molybdänsulfidschicht, welche die Funktion des Friktionskontaktes stabilisiert, bedeckt sein.

Die in den Darstellungen 40 und 41 abgebildeten Ultraschallaktoren 33 haben Stößel 35, die aus der gleichen Piezokeramik wie die piezoelektrische Platte 1 gefertigt sind. Zur Vermeidung bzw. Reduzierung von Abrieb sind-die Friktionsoberflächen mit der abriebfesten Schicht 37 versehen.

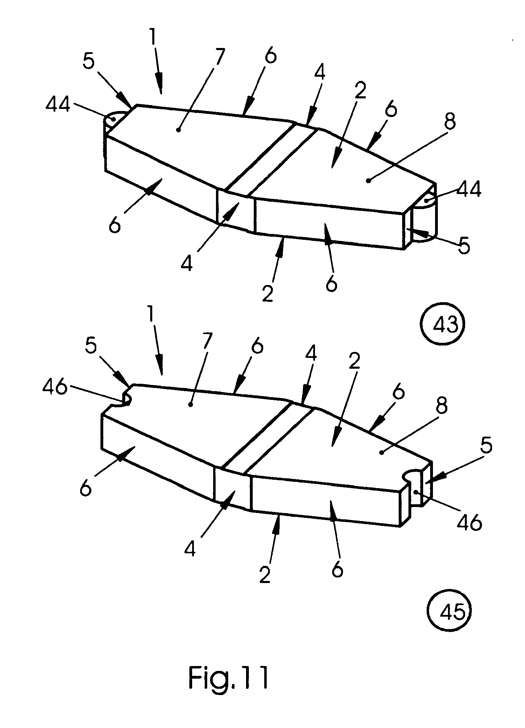

Fig.11 zeigt in der Darstellung 43 eine Ausführungsform des erfindungsgemäßen Ultraschallaktors, bei dem die Halteflächen 5 Fixierelemente 44 aufweisen. Die Fixierelemente 44 können während des Herstellungsprozesses aus der gleichen Piezokeramik wie die piezoelektrische Platte 1 gefertigt werden. Sie können aber auch aus anderen Materialien wie z.B. aus weichen Sorten von Oxidkeramik oder aus harten Polymerwerkstoffen gefertigt sein. In diesem Fall können die Fixierelemente 44 auf die Halteflächen 6 der piezoelektrischen Platte 1 aufgeschweißt oder aufgelötet werden. Das Aufschweißen erfolgt mittels leicht schmelzender Gläser oder mittels anderer, eine chemische Verbindung der Piezokeramik mit dem Material des Fixierelementes 44 eingehende Materialien. Das Aufkleben erfolgt mittels Epoxydharz oder mit Hilfe anderer ähnlicher Kleber.

In der Darstellung 45 der Fig. 11 ist eine weitere Ausführungsform des erfindungsgemäßen Ultraschallaktors gezeigt, bei dem die Halteflächen 5 Fixiernuten 46 aufweisen.

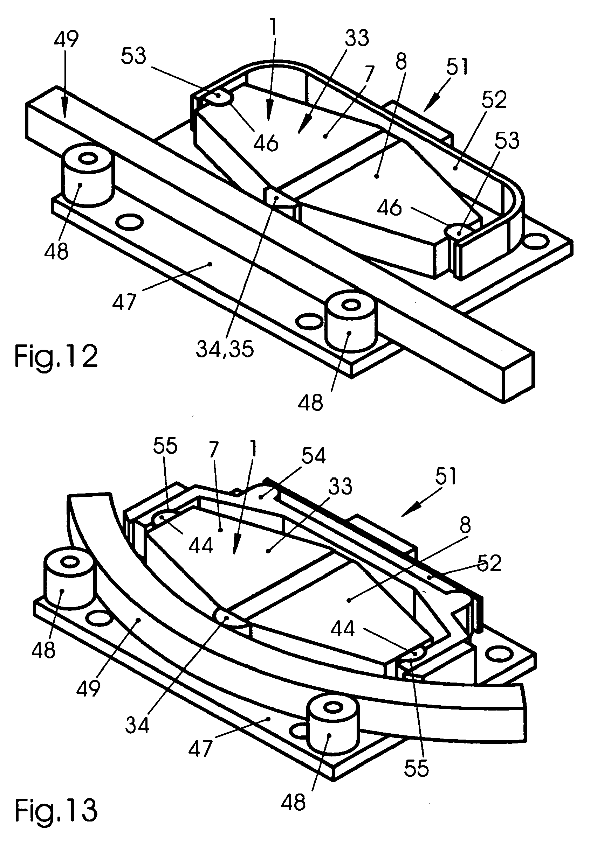

Fig. 12 zeigt ein erstes Anwendungsbeispiel des erfindungsgemäßen Ultraschallaktors in einem Ultraschallmotor. Dieser Motor hat eine Grundplatte 47 mit auf ihr befestigten Kugellagern 48, die ein als Stab ausgeführtes bewegliches Element 49 halten. Das Friktionselement 34 des Ultraschallaktors 33 wird an eine Friktionsoberfläche 50 des beweglichen Elementes 49 mit Hilfe einer Anpressvorrichtung 51 angepresst, welche eine Feder 52 aufweist, die gleichzeitig die piezoelektrische Platte 1 mit einer Buchse 53, die in den Fixiernuten 46 sitzt, hält.

Fig. 13 zeigt ein weiteres Anwendungsbeispiel des erfindungsgemäßen Ultraschallaktors in einem Ultraschallmotor. Hier ist das bewegliche Element 49 als Teil eines Ringes ausgeführt. Ebenso ist jedoch denkbar, dass das bewegliche Element 49 als kompletter Ring ausgeführt ist. Der Ultraschallaktor 33 dieses Motors wird mit Hilfe eines beweglichen Bügels 54 und der Anpressvorrichtung 51 gehalten. Der bewegliche Bügel 54 hat Nuten 55, in denen die Fixierelemente 44 der piezoelektrischen Platte 1 sitzen.

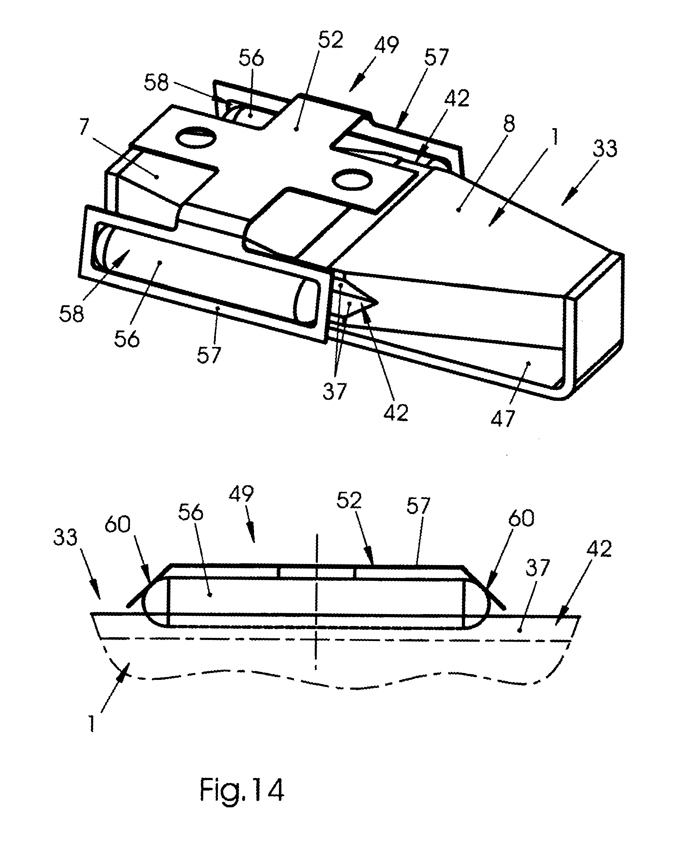

Fig. 14 zeigt ein weiteres Anwendungsbeispiel des erfindungsgemäßen Ultraschallaktors in einem Ultraschallmotor. Das bewegliche Element 49 weist hierbei zwei Läufer 56 auf, die sich in den Führungsnuten 42 der piezoelektrischen Platte 1 befinden. Die Läufer 56 werden durch die Feder 52 gehalten, die dafür Halter 57 mit Öffnungen 58 aufweist. Bei der in Darstellung 59 der Fig. 14 gezeigten Variante der Feder 52 werden die Läufer 56 durch gekrümmte Endteile 60 der Halter 57 gehalten.

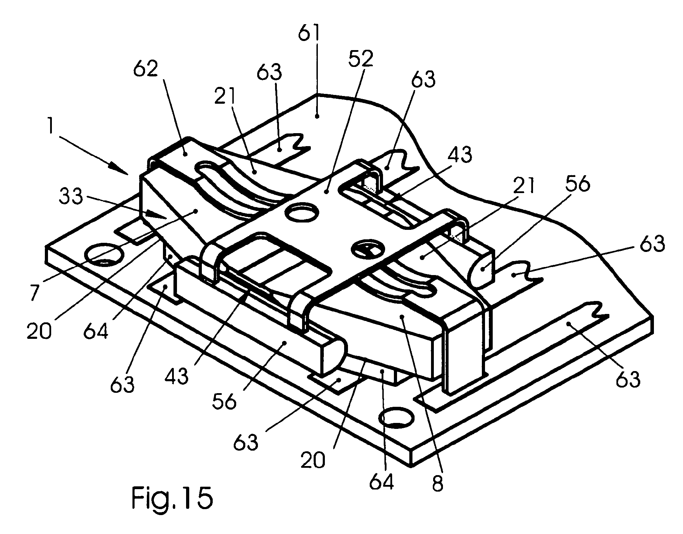

Fig. 15 zeigt ein weiteres Anwendungsbeispiel des erfindungsgemäßen Ultraschallaktors in einem Ultraschall motor, bei dem die piezoelektrische Platte 1 des Ultraschallaktors 33 auf einer Leiterplatte 61 angeordnet ist. Als Halter des Ultraschallaktors 33 dient ein Bügel 62, der gleichzeitig die Aufgabe des Leiters übernimmt, welcher die allgemeinen Elektroden 21 mit stromleitenden Bahnen 63 der Leiterplatte 61 verbindet. Die Erregerelektroden 20 sind mittels aus stromleitendem Gummi hergestellten Zwischenlagen 64 mit den stromleitenden Bahnen 63 verbunden. Die Leiterplatte 61 bildet gleichzeitig die Platte, auf der die Elektronikbauteile der elektrischen Erregervorrichtung 32 des Ultraschallaktors 33 angeordnet sind. Das bewegliche Element 49 dieses Motors besteht aus der Feder 52, die bei der Herstellung fest mit den aus Kunststoff gefertigten Läufern 56 verpresst wird. Die Läufer 56 können jedoch ebenso aus Metall, Keramik, Glass oder aus gefülltem Kunststoff, beispielsweise aus mit Glasfasern gefülltem Polyarylamid oder aus mit Kohlenstofffasern gefüllten Epoxydharz gefertigt sein.

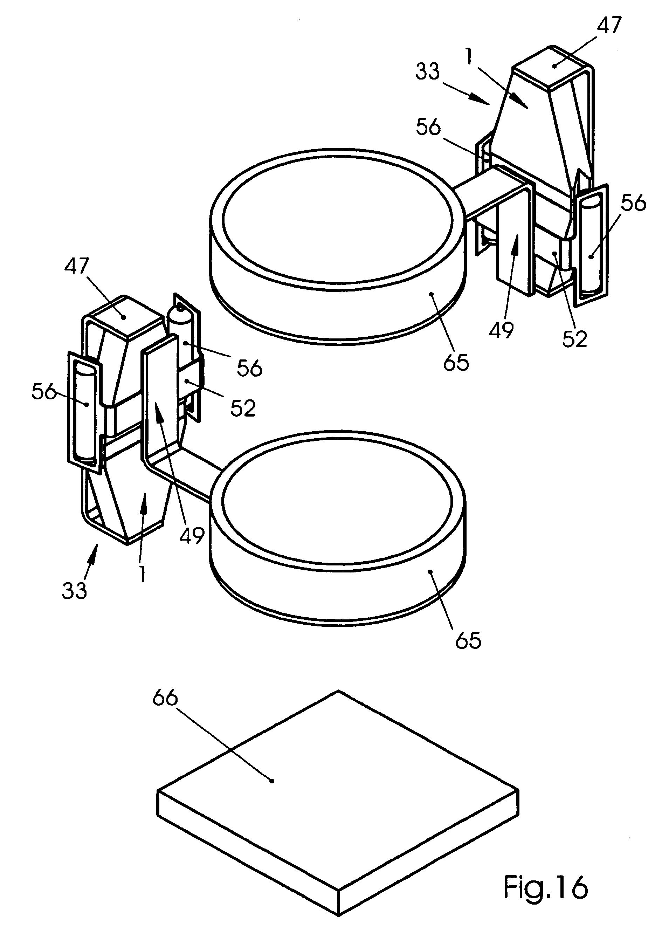

Fig. 16 zeigt ein weiteres Anwendungsbeispiel des erfindungsgemäßen Ultraschallaktors in einem Ultraschallmotor, wobei der Ultraschallmotor in einem Objektiv eines elektronischen Fotoapparates angeordnet ist. In diesem Objektiv kann eine bzw. können zwei oder drei Gruppen von optischen Linsen 65 zum Einsatz kommen. Dabei ist jede optische Linsengruppe 65 auf dem beweglichen Element 49 des entsprechenden Ultraschallmotors angeordnet. Die Grundplatte 47 jedes Motors wird im Objektivgehäuse (Gehäuse ist in Fig. 16 nicht dargestellt) befestigt. Dabei wird die mit dem Fotoobjektiv der optischen Linsengruppe 65 aufgenommene Abbildung auf einen Fotosensor 66 fokussiert.

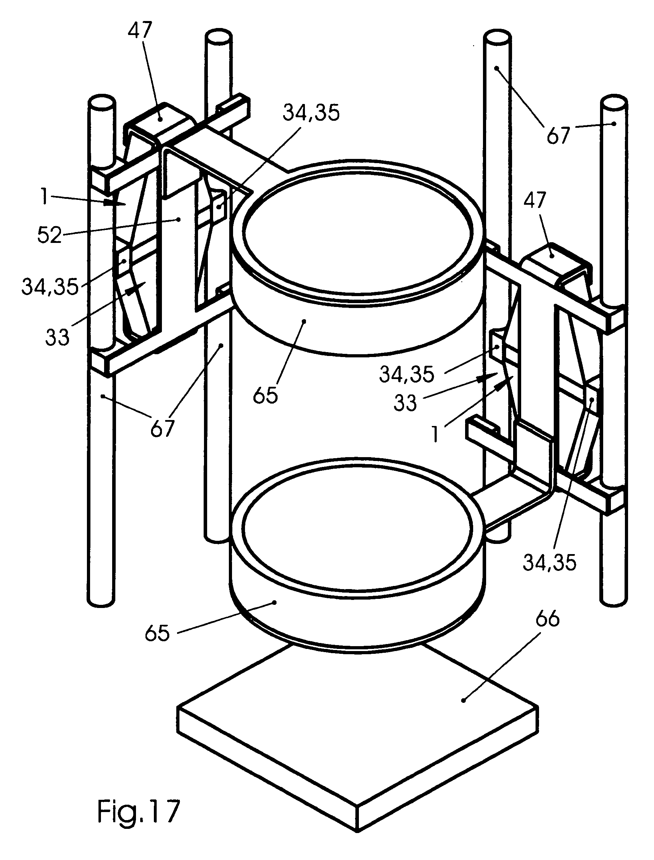

Fig. 17 zeigt ein weiteres Anwendungsbeispiel des erfindungsgemäßen Ultraschallaktors in einem Ultraschallmotor, wobei auch hier der Ultraschallmotor in einem Objektiv eines elektronischen Fotoapparates angeordnet ist. Bei diesem Objetiv bewegen sich die Ultraschallaktoren 33 auf im Objektivgehäuse angeordneten Führungen 67.

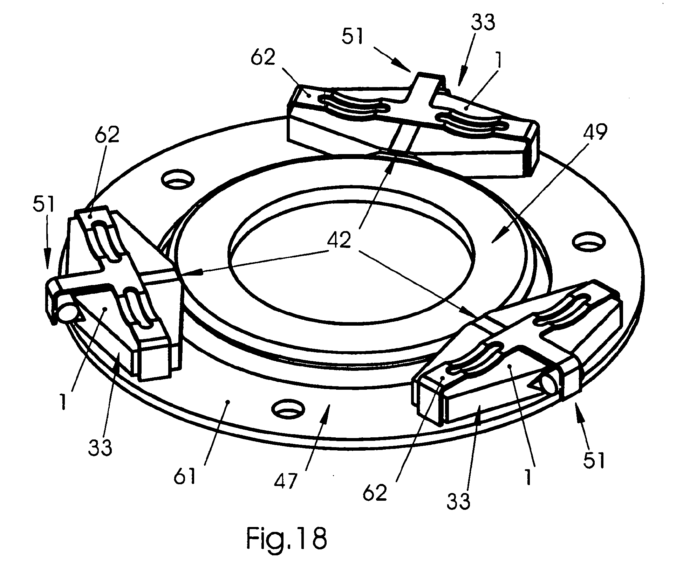

Fig. 18 zeigt ein weiteres Anwendungsbeispiel des erfindungsgemäßen Ultraschallaktors in einem Ultraschallmotor. Hierbei sind drei Ultraschallmotoren so angeordnet, dass sie das in Form eines Ringes vorliegende bewegliche Element 49 in eine Drehbewegung versetzen können.

Nachfolgend wird die Funktionsweise des erfindungsgemäßen Ultraschallaktors näher erläutert.

An einen der Generatoren für eine Ultraschallstehwelle, z. B. dem Generator 7 der piezoelektrischen Platte 1, wird von der Erregervorrichtung 23 über den Umschalter 24 (siehe Fig. 5) die Erregerspannung U angelegt, deren Frequenz in etwa gleich fo (siehe Fig. 6). Dabei wird in der piezoelektrischen Platte 1 eine akustische Stehwelle erzeugt. Da der Generator 7 asymmetrisch bezogen auf die Symmetrieebene Sq und symmetrisch bezogen auf die Symmetrieebene SI angeordnet ist, ist die Form der Stehwelle asymmetrisch zur Symmetrieebene Sq und symmetrisch zur Symmetrieebene SI. Die Form der erregten Welle wird durch die in den Darstellungen 28 und 29 der Fig. 7 gezeigten Abbildungen der maximalen Deformation wiedergegeben.

Die Ausbildung einer Stehwelle mit einer solchen Form kann durch zwei Gründe hervorgerufen werden. Im ersten Fall ist die erregte Stehwelle das Ergebnis der Überlagerung der ersten sich längs zur Höhe H der piezoelektrischen Platte 1 ausbreitenden Mode der symmetrischen Stehwelle mit der zweiten sich längs zur Länge L der piezoelektrischen Platte 1 ausbreitenden Mode. Beide Moden werden bei dicht nebeneinander liegenden Resonanzfrequenzen erzeugt, wodurch diese Resonanzen praktisch nicht voneinander unterscheidbar sind. Im zweiten Fall stellt die erzeugte Stehwelle eine einzelne Form einer asymmetrischen Stehwelle dar, die der gegebenen Form der piezoelektrischen Platte 1 eigen ist und auf ihrer eigenen Resonanzfrequenz erzeugt wird.

In beiden Varianten bewegen sich die im Zentrum der Oberfläche der Arbeitsflächen 4 befindenden Punkte 31 auf den in Fig. 8 dargestellten geneigten Bewegungsbahnen 30. Auf den gleichen Bewegungsbahnen bewegen sich auch die auf den Arbeitsflächen 4 der piezoelektrischen Platte 1 angeordneten Friktionselemente 34 oder Stößel 35 (siehe Fig. 9, 10, 11 und 13). Auf eben diesen Bewegungsbahnen bewegen sich auch die Punkte der Oberflächen der Führungsnuten 42. In allen Fällen führt die Bewegung auf den geneigten Bahnen zu einer gleichgerichteten Bewegung der an den Ultraschallaktor 33 angepressten beweglichen Elemente 49.

Durch das Verbinden des Generators 8 an Stelle des Generators 7 mit der elektrischen Erregervorrichtung 23 ändert sich der Neigungswinkel der Bewegungsbahn von β auf -β. Dies hat die Umkehr der Bewegungsrichtung des beweglichen Elementes 49 zur Folge.

Der positive Effekt der vorgeschlagenen Erfindung im Vergleich zum aus dem Stand der Technik bekannten Ultraschallaktor gemäß Druckschrift US 6,765,335 (Fig. 20) ergibt sich aus folgendem Grund. In dem aus dem Stand der Technik bekannten Ultraschallaktor besitzt die piezoelektrische Platte des Ultraschallmotors die in Fig. 2 gestrichelt dargestellte rechteckige Form. Die Querschnittsfläche der piezoelektrischen Platte des bekannten Ultraschallaktors bezogen auf die Ebene St ist gleich Q. Bei Erregung der piezoelektrischen Platte des bekannten Ultraschallaktors schwingt die gesamte piezoelektrische Platte. Dabei wird die Schwingungsfrequenz durch die Länge L und die Höhe H der piezoelektrischen Platte bestimmt.

In einer vereinfachten Betrachtungsweise kann angenommen werden, dass sich die mechanischen Verluste gleichmäßig in der Querschnittsfläche der piezoelektrischen Platte bezogen auf die Ebene St verteilen. Davon ausgehend ist die der piezoelektrischen Platte des bekannten Ultraschallaktors zugeführte elektrische Leistung proportional zu seiner Querschnittsfläche Q.

Bei den in den Darstellungen 11, 12 und 13 der Fig. 2 gezeigten drei Beispielfällen hat die piezoelektrische Platte 1 des Ultraschallaktors die mit durchgehender Linie dargestellte acht Seitenflächen aufweisende Form. Die Querschnittsfläche der piezoelektrischen Platte 1 bezogen auf die Ebene St entspricht qo für den Fall gemäß Darstellung 11, qm für den Fall gemäß Darstellung 12 und qn für den Fall gemäß Darstellung 13. Bei Erregung einer asymmetrischen Stehwelle in der piezoelektrischen Platte 1 des erfindungsgemäßen Ultraschallaktors schwingt die gesamte piezoelektrische Platte mit. Die Schwingungsfrequenz wird, wie auch im bekannten Ultraschallaktor, durch die Länge L und die Höhe H der piezoelektrischen Platte 1 bestimmt.

Für den erfindungsgemäßen Ultraschallaktor wie auch für den aus dem Stand der Technik bekannten Ultraschallaktor kann angenommen werden, dass sich die mechanischen Verluste proportional über die Querschnittsfläche der piezoelektrischen Platte 1 bezogen auf die Ebene St verteilen. Davon ausgehend ist die der piezoelektrischen Platte 1 des erfindungsgemäßen Ultraschallaktors zugeführte elektrische Leistung proportional zur Querschnittsfläche qo bzw. qm bzw. qn. Wenn die piezoelektrische Platte des bekannten Ultraschallaktors und die piezoelektrische Platte 1 des erfindungsgemäßen Ultraschallaktors die gleiche Länge L und die gleiche Höhe H aufweisen, und aus dem gleichen Typ von Piezokeramik mit den gleichen mechanischen Verlusten und dem gleichen Piezomodul hergestellt sind, muss zum Erreichen gleicher Schwingungsamplituden die eine wie auch die andere piezoelektrische Platte mit gleicher relativer Leistung erregt werden. D. h. die der piezoelektrischen Platte zugeführte elektrische Leistung, geteilt durch die Fläche des Querschnitts, muss in beiden Fällen gleich sein.

Da die piezoelektrische Platte 1 des erfindungsgemäßen Ultraschallaktors eine kleinere Querschnittsfläche bezogen auf die Ebene St hat, ist für seine Erregung eine geringere elektrische Leistung erforderlich. Für eine optimale Gestaltung der in Darstellung 11 der Fig. 12 gezeigten piezoelektrischen Platte 1 beträgt der Leistungsgewinn bei L/n=H/m=5 im Verhältnis zum bekannten Ultraschallaktor etwa 30%.

In einer realen piezoelektrischen Platte des bekannten Ultraschallaktors sind die mechanischen Verluste in der Praxis jedoch nicht gleichmäßig verteilt. An Ecken der piezoelektrischen Platten des bekannten Ultraschallaktors sind die Verluste höher, weshalb der reelle Leistungsgewinn im erfindungsgemäßen Ultraschallaktor im Verhältnis zum aus dem Stand der Technik bekannten Ultraschallaktor etwa 40-50 % beträgt.

Anders ausgedrückt bedeutet dies, dass durch Stutzen der Ecken der piezoelektrischen rechteckigen Platte des bekannten Ultraschallaktors der erfindungsgemäße Ultraschallaktor mit einer mindestens acht Seitenflächen aufweisenden piezoelektrischen Platte 1 resultiert, wodurch die für den Betrieb des erfindungsgemäßen Ultraschallaktors benötigte Leistung verringert wird. Dabei bleibt die Schwingungsamplitude des Ultraschallaktors erhalten, d.h. es wird die vom Ultraschallaktor auf das bewegliche Element 49 übertragene mechanische Leistung konstant gehalten. Durch die Verringerung der verbrauchten Leistung ist es möglich, die Erwärmung des Ultraschallaktors während des Betriebs zu reduzieren. Dies erhöht die Betriebsstabilität und seine Sicherheit.

Die optimalen Abmessungen der piezoelektrischen Platte 1 des erfindungsgemäßen Ultraschallaktors hängen geringfügig vom Typ der piezoelektrischen Keramik ab, aus dem die Platte hergestellt wird. Das bedeutet, dass die optimalen Abmessungen der piezoelektrischen Platte 1 für jeden Typ von Piezokeramik experimentell ermittelt werden müssen.

Bei der in Darstellung 16 der Fig. 4 gezeigten Ausführungsform der Generatoren 7 und 8 erfolgt die Erregung der asymmetrischen Welle aufgrund der Ausnutzung des Piezomoduls d₃₁. Eine solche Konstruktion der Generatoren 7 und 8 stellt die einfachste konstruktive Ausführung dar und kann deshalb in preiswerten Ultraschallaktoren, die bei ausreichend niedrigen Erregerspannungen arbeiten, eingesetzt werden.

Bei den in den Darstellungen 17 und 18 der Fig. 4 gezeigten Ausführungsformen der Generatoren 7 und 8 können die Elektroden 20 und 21 und die Anschlüsse 9 und 10 auf einer Seite der piezoelektrischen Platte 1 ausgeführt sein. Dies vereinfacht ebenso die Konstruktion des Ultraschallmotors.

Darstellung 19 in Fig. 4 zeigt eine piezoelektrische Platte 1 mit den in Multilayerform ausgeführten Generatoren 7 und 8. Die piezoelektrische Platte 1 mit solch ausgeführten Generatoren kann mit relativ niedrigen Spannungen angesteuert werden.

Durch die Wahl der entsprechenden Form für das Friktionselement 34 oder den Stößel 35 oder durch die Verwendung von Führungsnuten (siehe Fig. 9, 10) kann die Zugkraft am beweglichen Element 49 erhöht, die Bewegungsgeschwindigkeit des beweglichen Elements 49 erhöht oder verringert und seine Positioniergenauigkeit erhöht werden.

Durch die Verwendung der Fixierelemente 44 oder der Fixiernuten 46 (siehe Fig. 11) ist es möglich, die piezoelektrische Platte 1, wie z. B. in den Fig. 12 und 13 gezeigt, fest zu fixieren.

Der erfindungsgemäße Ultraschallaktor 33 kann bewegliche Elemente 49 unterschiedlichster Konstruktionen bzw. Formen in Bewegung versetzen. Dabei kann das bewegliche Element z. B. ein Stab (Fig. 12) oder ein Ring bzw. ein Teil eines Rings (Fig. 13) sein. Das bewegliche Element 49 kann darüber hinaus als Scheibe, Rohr, Kugel oder in jeder anderen durch die jeweilige Konstruktion vorgegebenen Form ausgeführt sein.

Außerdem kann das bewegliche Element 49 zwei Läufer 56 aufweisen und, wie in Fig. 14 dargestellt, aus mehreren Teilen zusammengesetzt sein. In diesem Fall können die Läufer 56 durch die Öffnungen 58 der Halter 57 der Feder 52 gehalten werden.

In einer anderen Variante können die Halter 57 konkave Endteile 60 aufweisen, die, wie in Position 59 der Abbildung 14 gezeigt, die Läufer 56 halten. In beiden Varianten ist es nicht erforderlich die Läufer 56 mit den Haltern 57 z. B. mittels Kleber fest zu verbinden, was die Montage des Ultraschallmotors vereinfacht.

Der Ultraschallmotor in Fig. 15 ist modular aufgebaut. In diesem Motor kann auf dem beweglichen Element 49 ein Laserreflektor oder ein anderes bewegliches Element einer optischen Baugruppe oder ein Miniaturkopf einer Speichereinheit (in der Abb. nicht dargestellt) montiert werden.

Bei dem in Fig. 16 schematisch dargestellten optischen Objektiv werden die optischen Linsengruppen 65 auf dem beweglichen Element 49 angeordnet. Eine solche Konstruktion des Objektivs ist möglich, wenn keine große Verschiebung der optischen Linsengruppe erforderlich ist.

Falls eine große Verschiebung der optischen Linsengruppe erforderlich ist, kann die in Fig. 17 dargestellte Konstruktion des Objektivs verwendet werden. In dieser Konstruktion wird der Ultraschallaktor 33 auf den Führungen 67 bewegt, wobei die Verschiebung nicht begrenzt ist.

Möglich ist auch eine Kombination der beiden in den Fig. 16 und 17 gezeigten Ausführungsformen.

Bei der in Fig. 18 gezeigten Ausführungsform wird das bewegliche Element 49 in Form einer Scheibe oder eines Ringes durch die drei Ultraschallaktoren 33 gehalten und in eine Drehbewegung versetzt.

Die hier aufgezeigte technische Lehre ermöglicht es, die erforderliche Leistung für die Erregung des erfindungsgemäßen Ultraschallaktors im Vergleich zu dem aus dem Stand der Technik gemäß Druckschrift US 6,765,335 bekannten Ultraschallaktor um etwa 40-50% zu senken. Durch die Verringerung der erforderlichen Leistung ist es möglich, die Erwärmung des Aktors zu reduzieren. Dies wiederum erhöht die Betriebsstabilität und Betriebssicherheit. Durch die niedrigere erforderliche Leistung ist es möglich, den erfindungsgemäßen Ultraschallaktor in miniaturisierten, preiswerten Geräten mit niedrigem elektrischem Energiebedarf wie z.B. in Objektiven von Miniaturfotoapparaten, in Objektiven für tragbare Kommunikationsmittel wie Handys, in miniaturisierten Speichereinheiten und in anderen ähnlichen Geräten, für die kleine Abmessungen, eine hohe Positioniergenauigkeit und ein geringer Energiebedarf für den Antrieb erforderlich sind, zu verwenden.

### Bezugsziffern

1. Piezoelektrische Platte
2. Hauptflächen
3. Piezoelektrische Platte 1 in Draufsicht
4. Arbeitsfläche
5. Haltefläche
6. Freie Fläche
7. Generator
8. Generator
9. Generatoranschluss
10. Generatoranschluss
11. Variante der piezoelektrischen Platte 1
12. Variante der piezoelektrischen Platte 1
13. Variante der piezoelektrischen Platte 1
14. Variante der piezoelektrischen Platte 1
15. Variante der piezoelektrischen Platte 1
16. Konstruktionsvariante des Generators 7 bzw. 8
17. Konstruktionsvariante des Generators 7 bzw. 8
18. Konstruktionsvariante des Generators 7 bzw. 8
19. Konstruktionsvariante des Generators 7 bzw. 8
20. Erregerelektrode
21. Gemeinsamen Elektrode
22. Piezokeramische Schicht
23. Elektrische Erregervorrichtung
24. Umschalter
25. Frequenzabhängigkeit der Impedanz Z der piezoelektrischen Platte 1
26. Frequenzabhängigkeit des Winkels φ
27. Resonanzpeak
28. Maximale Deformation der piezoelektrischen Platte 1
29. Maximale Deformation der piezoelektrischen Platte 1
30. Bewegungsbahnen der Punkte 31
31. Punkte im Zentrum der Arbeitsflächen 4
32. Variante des Ultraschallaktors 33
33. Ultraschallaktor
34. Friktionselement
35. Stößel
36. Varianten des Friktionselements 34 oder des Stößels 35
37. Abriebfeste Schicht
38. Variante des Ultraschallaktors 33
39. Variante des Ultraschallaktors 33
40. Variante des Ultraschallaktors 33
41. Variante des Ultraschallaktors 33
42. Führungsnut
43. Variante der piezoelektrischen Platte 1 des Ultraschallaktors 33
44. Fixierelement
45. Variante der piezoelektrischen Platte 1 des Ultraschallaktors 33
46. Fixiernut
47. Grundplatte
48. Kugellager
49. Bewegliches Element
50. Friktionsoberfläche
51. Anpressvorrichtung
52. Feder
53. Buchse
54. Beweglicher Bügel
55. Nuten im beweglichen Bügel 54
56. Läufer
57. Halter
58. Öffnung im Halter 57
59. Position mit konstruktiven Ausführungen des Halters 57
60. Endteil des Halters 57
61. Leiterplatte
62. Bügel
63. Stromleitende Bahn der Platte 60
64. Zwischenlage aus stromleitendem Gummi
65. Optische Linsengruppe
66. Fotosensor
67. Führung

## Patentansprüche

1. Ultraschallaktor, vorzugsweise für den Einsatz in einem Ultraschallmotor, in Form einer piezoelektrischen Platte (1) mit einer Länge L, einer Höhe H und einer Dicke t, wobei die piezoelektrische Platte (1) eine Quer-Symmetrieebene Sq, eine Längs-Symmetrieebene SI und wenigstens zwei Hauptflächen (2) aufweist, und die piezoelektrische Platte (1) zumindest zwei symmetrisch zu der Symmetrieebene Sq angeordnete Generatoren (7, 8) zur Erzeugung von Ultraschallstehwellen umfasst,
**dadurch gekennzeichnet, dass**
die piezoelektrische Platte (1) eine wenigstens acht Seitenflächen umfassende Form aufweist, wobei wenigstens zwei der Seitenflächen zur Kontaktierung von anzutreibenden Elementen vorgesehene Arbeitsflächen (4) sind, und wenigstens zwei der Seitenflächen zur Halterung der piezoelektrischen Platte (1) vorgesehene Halteflächen (5) sind, und die übrigen Seitenflächen freie Flächen (6) sind, wobei zumindest vier freie Flächen (6) unter einem gleichen Winkel α zu der Längs-Symmetrieebene SI und/oder unter einem gleichen Winkel φ zu der Quer-Symmetrieebene Sq angeordnet sind.

2. Ultraschallaktor nach Anspruch 1,
**dadurch gekennzeichnet, dass**
die Arbeitsflächen (4) eine Breite n aufweisen, und die Halteflächen (5) eine Breite m aufweisen, und das Verhältnis L zu n und/oder das Verhältnis H zu m im Bereich zwischen 1,1 bis 9 liegt und vorzugsweise etwa gleich 5 ist.

3. Ultraschallaktor nach Anspruch 1 oder 2,
**dadurch gekennzeichnet, dass**
das Verhältnis L zu H im Bereich zwischen 1,5 und 3 liegt und vorzugsweise etwa gleich 2 ist.

4. Ultraschallaktor nach zumindest einem der vorangegangenen Ansprüche,
**dadurch gekennzeichnet, dass**
das Verhältnis L zu t im Bereich zwischen 5 und 15 liegt und vorzugsweise etwa gleich 10 ist.

5. Ultraschallaktor nach zumindest einem der vorangegangenen Ansprüche,
**dadurch gekennzeichnet, dass**
jeder der Generatoren (7,8) eine Erregerelektrode (20) und eine allgemeine Elektrode (21) umfasst, die auf den Hauptflächen (2) der piezoelektrischen Platte (1) angeordnet sind, und zwischen der Erregerelektrode (20) und der allgemeinen Elektrode (21) eine piezoelektrische Keramik angeordnet ist.

6. Ultraschallaktor nach zumindest einem der vorangegangenen Ansprüche,
**dadurch gekennzeichnet, dass**
jeder der Generatoren (7,8) mehrere Schichten von Erregerelektroden (20), allgemeinen Elektroden (21) und jeweils zwischen diesen angeordnete Schichten aus piezoelektrischer Keramik (22) aufweist, wobei besagte Schichten (22) parallel zu den Hauptflächen (2) der piezoelektrischen Platte (1) angeordnet sind.

7. Ultraschallaktor nach zumindest einem der vorangegangenen Ansprüche,
**dadurch gekennzeichnet, dass**
zumindest eine der Arbeitsflächen (4) wenigstens ein Friktionselement (34) oder wenigstens einen Stößel (35) aufweist.

8. Ultraschallaktor nach zumindest einem der vorangegangenen Ansprüche,
**dadurch gekennzeichnet, dass**
wenigstens eine der Arbeitsflächen (4) zumindest abschnittsweise eine Führungsnut (42) aufweist.

9. Ultraschallaktor nach zumindest einem der vorangegangenen Ansprüche,
**dadurch gekennzeichnet, dass**
das Friktionselement (34) und/oder der Stößel (35) und/oder die Führungsnut (42) an der Oberfläche zumindest abschnittsweise eine abriebfeste Schicht (37) aufweist bzw. aufweisen.

10. Ultraschallaktor nach zumindest einem der vorangegangenen Ansprüche,
**dadurch gekennzeichnet, dass**
zumindest eine der Halteflächen wenigstens ein Fixierelement (44) oder zumindest abschnittsweise eine Fixiernut (46) aufweist.

## Claims

1. Ultrasonic actuator, preferably for use in an ultrasonic motor, in the form of a piezoelectric plate (1) with a length L, a height H and a thickness t, wherein the piezoelectric plate (1) has a lateral plane of symmetry Sq, a longitudinal plane of symmetry SI and at least two main surfaces (2), and the piezoelectric plate (1) comprises at least two generators (7, 8) arranged symmetrically with respect to the plane of symmetry Sq for generating ultrasonic standing waves,
**characterized in that**
the piezoelectric plate (1) has a shape that includes at least eight lateral faces, wherein at least two of the lateral faces are working surfaces (4) provided to contact elements to be driven, and at least two of the lateral faces are holding surfaces (5) provided to hold the piezoelectric plate (1), and the remaining lateral faces are free surfaces (6), wherein at least four free surfaces (6) are arranged at a same angle α with respect to the longitudinal plane of symmetry SI and/or at a same angle ϕ with respect to the lateral plane of symmetry Sq.

2. Ultrasonic actuator according to claim 1,
**characterized in that**
the working surfaces (4) have a width n and the holding surfaces (5) have a width m, and that the ratio L to n and/or the ratio H to m is in the range between 1.1 and 9, and is preferably approximately equal to 5.

3. Ultrasonic actuator according to claim 1 or 2,
**characterized in that**
the ratio L to H is in the range between 1.5 and 3, and is preferably approximately equal to 2.

4. Ultrasonic actuator according to at least one of the preceding claims,
**characterized in that**
the ratio L to t is in the range between 5 and 15, and is preferably approximately equal to 10.

5. Ultrasonic actuator according to at least one of the preceding claims,
**characterized in that**
each of the generators (7, 8) comprises an excitation electrode (20) and a general electrode (21), which are arranged on the main surfaces (2) of the piezoelectric plate (1), and that a piezoelectric ceramics is arranged between the excitation electrode (20) and the general electrode (21).

6. Ultrasonic actuator according to at least one of the preceding claims,
**characterized in that**
each of the generators (7, 8) comprises several layers of excitation electrodes (20), general electrodes (21) and layers of piezoelectric ceramics (22) each arranged there between, wherein said layers (22) are arranged in parallel to the main surfaces (2) of the piezoelectric plate (1).

7. Ultrasonic actuator according to at least one of the preceding claims,
**characterized in that**
at least one of the working surfaces (4) comprises at least one friction element (34) or at least one slide (35).

8. Ultrasonic actuator according to at least one of the preceding claims,
**characterized in that**
at least one of the working surfaces (4) comprises at least section-wise a guide groove (42).

9. Ultrasonic actuator according to at least one of the preceding claims,
**characterized in that**
the friction element (34) and/or the slide (35) and/or the guide groove (42) has/have at least section-wise an abrasion-resistant layer (37) on the surface.

10. Ultrasonic actuator according to at least one of the preceding claims,
**characterized in that**
at least one of the holding surfaces comprises at least one fixing element (44) or at least section-wise a fixing groove (46).

## Revendications

1. Actionneur à ultrasons, de préférence pour l'emploi dans un moteur à ultrasons, sous la forme d'une plaque piézo-électrique (1) avec une longueur L, une hauteur H et une épaisseur t, ladite plaque piézo-électrique (1) présentant un plan de symétrie transversal Sq, un plan de symétrie longitudinal SI et au moins deux surfaces principales (2), et la plaque piézo-électrique (1) comprend au moins deux générateurs (7, 8), agencés symétriquement par rapport au plan de symétrie Sq pour la génération d'ondes stationnaires ultrasonores,
**caractérisé en ce que**
la plaque piézo-électrique (1) présente une forme comprenant au moins huit surfaces latérales, de sorte qu'au moins deux des surfaces latérales sont destinées à venir en contact avec des surfaces de travail (4) prévues sur des éléments à entraîner, et au moins deux des surfaces latérales sont des surfaces de maintien (5) prévues pour le maintien de la plaque piézo-électrique (1), et les surfaces latérales restantes sont des surfaces libres (6), dans lesquelles au moins quatre surfaces libres (6) sont agencées sous un même angle α par rapport au plan de symétrie longitudinal SI et/ou sous un même angle ϕ par rapport au plan de symétrie transversal Sq.

2. Actionneur à ultrasons selon la revendication 1,
**caractérisé en ce que** les surfaces de travail (4) ont une largeur n, et les surfaces de maintien (5) ont une largeur m, et le rapport L sur n et/ou le rapport H sur m tombe dans la plage entre 1,1 et 9, et est de préférence environ égal à 5.

3. Actionneur à ultrasons selon la revendication 1 ou 2,
**caractérisé en ce que** le rapport L sur H tombe dans la plage entre 1,5 et 3, et est de préférence environ égal à 2.

4. Actionneur à ultrasons selon l'une au moins des revendications précédentes,
**caractérisé en ce que** le rapport L sur t tombe dans la plage entre 5 et 15, et est de préférence environ égal à 10.

5. Actionneur à ultrasons selon l'une au moins des revendications précédentes,
**caractérisé en ce que** chacun des générateurs (7, 8) comprend une électrode d'excitation (20) et une électrode générale (21), lesquelles sont agencées sur les surfaces principales (2) de la plaque piézo-électrique (1), et une céramique piézo-électrique est agencée entre l'électrode d'excitation (20) et l'électrode générale (21).

6. Actionneur à ultrasons selon l'une au moins des revendications précédentes,
**caractérisé en ce que** chacun des générateurs (7, 8) comprend plusieurs couches d'électrodes d'excitation (20), d'électrodes générales (21) et des couches respectives agencées entre celle-ci en céramique piézo-électrique (22), lesdites couches (22) étant agencées parallèlement aux surfaces principales (2) de la plaque piézo-électrique (1).

7. Actionneur à ultrasons selon l'une au moins des revendications précédentes,
**caractérisé en ce que** l'une au moins des surfaces de travail (4) comprend au moins un élément à friction (34) ou au moins un poussoir (35).

8. Actionneur à ultrasons selon l'une au moins des revendications précédentes,
**caractérisé en ce que** l'une au moins des surfaces de travail (4) présente au moins par tronçon une gorge de guidage (42).

9. Actionneur à ultrasons selon l'une au moins des revendications précédentes,
**caractérisé en ce que** l'élément à friction (34) et le poussoir (35) et/ou la gorge de guidage (42) présente(nt) sur la surface au moins par tronçon une couche (37) résistant à l'abrasion.

10. Actionneur à ultrasons selon l'une au moins des revendications précédentes,
**caractérisé en ce que** l'une au moins des surfaces de maintien comprend au moins un élément de fixation (44), ou bien une gorge de fixation (46) au moins par tronçon.
